# EUROPEAN PATENT APPLICATION

(11) **EP 4 538 689 A1**
(43) Date of publication of application: **16.04.2025**
(21) Application number: 23202673.2
(22) Date of filing: 10.10.2023
(51) Int. Cl.: G01N 24/10, G01R 33/32, G01R 33/60, G01R 33/30

(54) **RAPID SEQUENTIAL PROBING OF OPTICALLY ADDRESSABLE SOLID-STATE SPIN SYSTEMS AT A PLURALITY OF PROBING POSITIONS**

(71) Applicant: Technische Universität München, 80333 München (DE)
(72) Inventor: BUCHER, Dominik Benjamin, 82178 Puchheim (DE); LEIBOLD, Joachim Paul, 81669 München (DE)
(74) Representative: Lucke, Andreas

(57) **Abstract**

Disclosed herein is a method for probing optically addressable solid-state spin systems at a plurality of probing positions and a device for probing optically addressable solid-state spin systems. The method comprises sequentially scanning a focused light beam across said plurality of probing positions and, at each probing position, illuminating solid-state spin systems at the respective probing position with said focused light beam. A scanning duration within which said focused light beam is scanned across said plurality of probing positions is shorter than three times a spin-lattice relaxation time of said solid-state spin systems and/or shorter than three times a spin-spin relaxation time of said solid-state spin systems.

## Description

### FIELD OF THE INVENTION

The present invention is in the field of quantum sensing, in particular magnetic sensing using solid-state spin systems as quantum sensors. The invention relates to a method for probing optically addressable solid-state spin systems at a plurality of probing positions and to a device for probing optically addressable solid-state spin systems.

### BACKGROUND

High-throughput parallelized analysis of samples is essential for many applications in chemistry, life sciences, and medicine. Such experiments may for example be conducted on microfluidic chips comprising a plurality of microfluidic sample wells, in which a large number of samples may be provided and processed simultaneously. Due to the small sample volumes involved, however, these experiments are so far limited to highly sensitive detection techniques such as fluorescence spectroscopy or mass spectrometry.

Nuclear magnetic resonance (NMR) spectroscopy may allow for resolving structures on the molecular level and molecular dynamics as well as for a quantitative, non-destructive analysis of samples. Yet, in contrast to the aforementioned methods, NMR spectroscopy typically requires larger samples and expensive devices, which has so far prevented the parallelized analysis of samples on a large scale.

In recent years, rapid progress has been made in using quantum technologies for various sensing applications. A prominent example thereof are nitrogen-vacancy (NV) centers in diamond, see, e.g., R. Schirhagl et al., Annu. Rev. Phys. Chem. 65, 83-105 (2014*),* A. Boretti et al., Beilstein J. Nanotechnol. 10, 2128-2151 (2019*)* and S. C. Scholten et al., J. Appl. Phys. 130, 150902 (2021*).* These point-like defects constitute a versatile quantum system exhibiting an atom-like energy spectrum with electronic and spin degrees of freedom, which react to external electric and magnetic fields and can moreover be manipulated with light and microwaves. NV centers can thus, e.g., be used as nanoscale magnetometers with optical readout for detecting magnetic fields. This for example allows for performing NMR spectroscopy on picolitre volumes, e.g., as reported in D. R. Glenn et al., Nature 555, 351-354 (2018*)* and WO 2018/052497 A2, for recording single-shot magnetic resonance spectra as, e.g., described in WO 2018/128543 A1, and for detecting NMR signals from surface monolayers as reported in K. S. Liu et al., PNAS 2022, Vol. 119, No. 5, e2111607119*.*

This approach could in principle be extended to a plurality of samples or larger sample volumes, e.g., using an array of selectively addressable sites each of which comprises one or more NV centers, for example as described in H. Zhang et al., npj Quantum Inf. 3:31 (2017*)* and M. Cai et al., Adv. Quantum Technol. 2023, 2200175*.* However, the laser power required for simultaneously exciting NV centers at multiple sites prevents parallel measurements at more than a handful of sites due to limitations in the output power of available laser sources, the risk of damaging samples and optical elements at high light intensities as well as the high cost and expensive optics associated with high laser powers. Moreover, spatially resolving photodetectors such as CMOS sensors for simultaneously detecting signals from multiple sites may only provide an insufficient sensitivity. For probing larger number of samples or larger sample volumes and/or for improving the achievable signal-to-noise ratio, time-consuming serial measurements may thus be required.

### SUMMARY OF THE INVENTION

The object of the invention is therefore to enable high-throughput probing of samples using nitrogen-vacancy centers with improved signal-to-noise ratio while avoiding excessive laser power demand and preventing damage to the samples.

This object is met by a method for probing optically addressable solid-state spin systems at a plurality of probing positions according to claim 1 and a device for probing optically addressable solid-state spin systems according to claim 10. Embodiments of the present invention are detailed in the dependent claims.

The method for probing optically addressable solid-state spin systems at a plurality of probing positions according to the invention comprises sequentially scanning a focused light beam across the plurality of probing positions. At each probing position, solid-state spin systems at the respective probing position are illuminated with the focused light beam. A scanning duration within which the focused light beam is scanned across the plurality of probing positions is shorter than three times a spin-lattice relaxation time of the solid-state spin systems and/or shorter than three times a spin-spin relaxation time of the solid-state spin systems.

The method may for example be performed using (e.g., by) a device for probing optically addressable solid-state spin systems according to any one of the embodiments disclosed herein. The method may be used for (e.g., comprise) probing one or more samples using the solid-state spin systems (by probing the solid-state spin systems, i.e., using the solid-state spin systems as probes), for example as detailed below for the device according to the invention. In other examples, the solid-state spin systems themselves may be the "samples" to be probed.

The optically addressable solid-state spin systems maybe quantum systems with a spin degree of freedom that are arranged or embedded in a solid host material (solid-state matrix, e.g., a substrate or a part thereof such as a sensing layer). The spin degree of freedom can be read out and/or manipulated via optical transitions and/or a microwave (MW) and/or radio-frequency (rf) field. The spin systems may in particular be objects that behave like artificial atoms or molecules, i.e., systems that exhibit an atom- or molecule-like energy spectrum and have at least two different spin states. The spin systems may for example be optically active defects in a crystal structure. Energy levels of different spin states may shift in the presence of a magnetic field. Furthermore, a spin system may for example have a spin-state dependent transition rate between different states of the spin system, e.g., different electronic states of the spin system. This may manifest in a spin-state dependent luminescence upon optical illumination. The solid-state spin systems may thus for example be used as a probe for a magnetic field, e.g., by determining an energy difference and/or a transition rate between states of the spin systems.

In a preferred embodiment, the solid-state spin systems are or comprise diamond color centers (e.g., in a diamond host material), i.e., optically active point defects in the diamond crystal structure. Preferably, the spin systems are nitrogen-vacancy (NV) centers in diamond, in particular negatively charged nitrogen-vacancy centers. Additionally or alternatively, the solid-state spin systems may for example be or comprise spin defects in a van-der-Waals material. The van-der-Waals material may comprise or consist of stacked two-dimensional layers, e.g., monolayers, (weakly) bound to each other by van-der-Waals forces, wherein atoms in the two-dimensional layers may be strongly bound to each other, e.g., by covalent bonds, for example in a particular crystal structure. Examples of van-der-Waals materials comprise graphite, graphene, hexagonal boron nitride (hBN), and transition metal dichalgonites (TMD) such as molybdenum disulfide (MoS₂). In hBN, the solid-state spin systems may for example be boron vacancy centers, in particular negatively charged boron vacancy centers. In some examples, the solid-state spin systems may additionally or alternatively also be or comprise spin defects in a semiconductor material such as for example silicon carbide (SiC). Additionally or alternatively, the solid-state spin systems may also be or comprise quantum dots having a spin degree of freedom.

Each of the probing positions may be a position at which solid-state spin systems are to be probed (e.g., to determine information pertaining to a state, in particular a spin state, thereof, which in turn may serve as a probe for determining information pertaining to a sample that the respective solid-state spin system interacts or has interacted with). At each probing position, there may be a plurality of solid-state spin system (e.g., an ensemble of a large number of solid-state spin systems). In other examples, there may only be a single solid-state spin system (or a smaller number of spin systems) at some or all of the probing positions. Some or all of the probing positions may be adjacent to a sample to be probed using the solid-state spin systems, e.g., as detailed below. The probing positions may be spatially separated from each other (i.e., may be arranged at a finite distance from each other, e.g., as detailed below). The plurality of probing positions may for example comprise between 2 and 10 000, in some examples between 5 and 1 000, in one example between 10 and 200 probing positions. In some examples, some or all of the probing positions may directly abut each other (for example be arranged at a distance from each other that is much smaller than, e.g., less than 10% of, a diameter of the focused light beam). Some or all of the probing positions may for example be continuously arranged (e.g., at an infinitesimally small spacing) along a contiguous path or over a contiguous region.

The focused light beam is sequentially scanned across the plurality of probing positions, i.e., such that the light beam is directed at the individual probing positions one after the other. Put differently, the light beam is moved across the plurality of probing positions from one probing position to the next such that the focused light beam (e.g., a center thereof) is at (e.g., intersects with) each of the probing positions at a different point in time. The focused light may for example be scanned using an optical deflector for deflecting the focused light beam, e.g. as detailed below. To scan the light beam across the plurality of probing positions, the light beam may for example be moved along a scan path connecting the probing positions with each other, i.e., intersecting with each of the probing positions. The focused light beam may be scanned along one direction (e.g., along a straight line) or along two directions (e.g., sequentially along a plurality of straight lines as for example in a zig-zag or sawtooth-shaped scan path). The scan path is not particularly limited and may in principle take any one- or two-dimensional line geometry (i.e., may be a path of arbitrary shape). In some examples, the light beam is scanned such that at each point in time (at most) a single probing position is illuminated. While moving the light beam between probing positions, the light beam may be off, i.e., the light beam does not necessarily have to be on continuously during the scan but may for example only be switched on when a probing position has been reached (for illuminating solid-state spin systems at the respective probing position) and switched off before moving to the next probing position. In other examples, the light beam may be on while moving the light between probing positions, e.g., continuously on during some or all of the scan.

At each probing position, solid-state spin systems at the respective probing position are illuminated with the focused light beam, for example the solid-state spin systems within a sensing region around the respective probing position defined by the extent of the focused light beam (i.e., within an illumination spot in a (larger) sensing area such as a sensing layer illuminated by the focused light beam). The solid-state spin systems may for example be illuminated for optical readout, e.g., to determine information pertaining to a state, in particular a spin state, thereof, for example as detailed below. In other examples, the solid-state spin systems may additionally (or alternatively) be illuminated for other purposes, for example for initializing the solid-state spin systems in a particular initial state, e.g., by optical polarization or optical pumping. Preferably, the focused light beam is focused onto the respective probing position, for example onto a substrate or a sensing area or layer containing the solid-state spin systems, or in the vicinity thereof. In some examples, the solid-state spin systems may be illuminated such that the focused light beam is reflected at a surface or interface at the respective probing position or in the vicinity thereof, for example by total internal reflection.

The scanning duration within which the focused light beam is scanned across said plurality of probing positions (e.g., from the first probing position to be illuminated to the last probing position to be illuminated, i.e., along the entire scan path) is shorter than three times (i.e., 300% of) a spin-lattice relaxation time of the solid-state spin systems and/or shorter than three times (i.e., 300% of) a spin-spin relaxation time of the solid-state spin systems (i.e., at least shorter than three times the longer one of the spin-lattice and spin-spin relaxation times and optionally also shorter than three times the shorter one of the spin-lattice and spin-spin relaxation times). In some examples, the scanning duration is shorter than two times (i.e., 200% of) the spin-lattice relaxation time of said solid-state spin systems and/or shorter than two times (i.e., 200% of) the spin-spin relaxation time of said solid-state spin systems. Preferably, the scanning duration is shorter than one or both of the spin-lattice relaxation time and the spin-spin relaxation time of said solid-state spin systems. Most preferably, the scan duration is substantially shorter than one or both of the spin-lattice relaxation time and the spin-spin relaxation time. As used herein, a first duration or time may for example be considered to be "substantially shorter" than a second duration or time if the first duration or time is shorter than 50%, in some examples shorter than 20%, in some examples shorter than 10%, in some examples shorter than 5%, in one example shorter than 2% and in one example shorter than 1% of the second duration or time. In other words, the scanning duration may for example be shorter than 50%, in some examples shorter than 20%, in some examples shorter than 10%, in some examples shorter than 5%, in one example shorter than 2% and in one example shorter than 1% of the spin-lattice relaxation time. Additionally or alternatively, the scanning duration may for example be shorter than 50%, in some examples shorter than 20%, in some examples shorter than 10%, in some examples shorter than 5%, in one example shorter than 2% and in one example shorter than 1% of the spin-spin relaxation time.

The spin-lattice relaxation time (which may also be referred to as the T1 relaxation time or T1 in short) is the time scale characterizing the relaxation of the longitudinal spin component (S_{z} component, e.g., with respect to an external bias magnetic field) of the solid-state spin systems (e.g., the occupation probabilities of the different spin states) towards its equilibrium value, for example due to interaction with the surrounding host material ("lattice"). The spin-spin relaxation time (which may also be referred to as the T2 relaxation time or T2 in short and is typically, but not necessarily shorter than the spin-lattice relaxation time) is the time scale characterizing the relaxation of the transverse spin component (S_{xy} component, e.g., with respect to the external bias magnetic field) of the solid-state spin systems towards its equilibrium value (for example a dephasing or decoherence of the solid-state spin systems, e.g., of the phases of their respective quantum state). As used herein, the spin-lattice and spin-spin relaxation times refer to the spin-lattice and spin-spin relaxation time, respectively, within the relevant set or manifold of spin states to be probed (e.g., the set or manifold of spin states populated by the solid-state spin systems prior to illumination with the focused light beam). This set or manifold of spin states may, e.g., be associated with a particular electronic state of the solid-state spin system (such as the electronic state that the solid-state spin systems are in prior to illumination with the focused light beam), in particular the electronic ground state of the solid-state spin system. The spin-lattice and spin-spin relaxation times of the solid-state spin systems may for example be defined as the average spin-lattice and spin-spin relaxation time, respectively, over the entire ensemble of solid-state spin systems in the host material (e.g., in the entire substrate or sensing area/layer) or the average spin-lattice and spin-spin relaxation time, respectively, over a subset thereof, for example the solid-state spin systems at the probing positions (e.g., within the corresponding sensing regions).

In some examples, the scanning duration may be shorter than three times an effective spin-spin relaxation time, in some examples shorter than two times the effective spin-spin relaxation time, in some examples shorter than the effective spin-spin relaxation time and in one example substantially shorter (e.g., as described above) than the effective spin-spin relaxation time of the solid-state spin systems (which may also be referred to as the T2^{∗} relaxation time or T2^{∗} in short). The effective spin-spin relaxation time - unlike the (intrinsic) spin-spin relaxation time - may for example additionally take into account dephasing as a result of local magnetic field inhomogeneities (i.e., non-random dephasing, which may for example be recovered by spin echo experiments) and may thus be shorter than the T2 spin-spin relaxation time.

The spin-lattice and spin-spin relaxation times may depend (among others) on the type of solid-state spin system, the host material and the depth below the host material surface at which the spin systems are arranged. Typically, the spin-spin relaxation time is shorter than the spin-lattice relaxation time but in some exceptional cases the spin-spin relaxation time may also be longer than the spin-lattice relaxation time. For solid-state spin systems such as NV centers, the spin-spin relaxation time may for example be between 0.5 µs and 1 ms, in some examples between 1 µs and 500 µs, in one example between 1 µs and 20 µs (e.g., for solid-state spin systems such as NV centers at or close to the surface) and in one example between 100 µs and 500 µs (e.g., for solid-state spin systems such as NV centers further below the surface). The spin-lattice relaxation time for such solid-state spins systems, on the other hand, may for example be between 0.1 ms and 100 ms, in some examples between 0.5 ms and 50 ms and in some examples between 1 ms and 10 ms. A scanning velocity (e.g., the velocity with which the light beam is moved between the probing positions) may be chosen accordingly (e.g., based on the spin-lattice and/or spin-spin relaxation times and the spacing between the probing positions or length of the scan path) to achieve a sufficiently short scanning duration. The scanning velocity may for example be between 104 mm/µs and 10² mm/µs, in some examples between 10⁻³ mm/µs and 10² mm/µs and in some examples between 10⁻² mm/µs and 10¹ mm/µs, although its value may vary substantially depending on the specific implementation and in particular the spacing between probing positions and the number of probing positions to be scanned (which determine the total length of the scan path) and the illumination time required at each probing position for illuminating the solid-state spin systems.

By scanning the light beam across the plurality of probing positions within a scanning duration shorter than three times the spin-lattice and/or spin-spin relaxation times, the method according to the invention allows for sequentially illuminating the solid-state spin systems at all probing positions before the longitudinal spin component and/or the transversal spin component relaxes to its respective equilibrium value, i.e., before the information pertaining to the spin state populations in the respective spin states and/or the phase of the spin state of the solid-state spin systems is lost. This may for example allow for "quasi-simultaneously" probing the spin state of the solid-state spin systems at all probing positions by rapid sequential optical readout. At the same time - and in contrast to parallel readout schemes as for example disclosed in M. Cai et al., Adv. Quantum Technol. 2023, 2200175 - the entire intensity of the light beam may be focused onto a single probing position, which not only reduces the amount of (laser) power required but may also result in improved homogeneity of the illumination over the probing positions. As the spin population and/or the phase is preserved to at least a sizeable extent during readout, other parts of the probing sequence such as microwave manipulation and/or interaction with the samples may be performed simultaneously at all probing positions, which may be advantageous both with regard to the comparability of measurements at different probing positions and the duration of the entire measurement protocol (thus, e.g., allowing for fast repetitions, which may yield substantial improvements in sensitivity and signal-to-noise ratio). Furthermore, as detailed below, the sequential scanning may allow for spatially resolved detection even with point-like photodetectors by time-encoding of spatial information.

The focused light beam may be scanned across the plurality of probing positions by deflecting the light beam along one or two directions using an optical deflector, for example as described below for the device according to the invention. The deflection of the light beam using the optical deflector may not involve the use of any movable parts (as, e.g., in mirror-based mechanical deflectors such as digital micromirror devices and galvanometer scanners) but may for example be achieved using electrical and/or acoustical signals. This may allow for achieving sufficiently fast deflection/scanning velocities as well as sufficiently low response times. The optical deflector may for example be or comprise one or more electro-optic modulators (EOMs, which may for example primarily be designed or used for modulation but may also cause deflection of a light beam), one or more electro-optic deflectors (EODs) and/or one or more electro-optic devices acting both as a deflector and as a modulator. For the sake of simplicity, the terms "electro-optic modulator" and "electro-optic modulator and/or deflector" may be used herein to refer to any one of an electro-optic modulator, an electro-optic deflector and a combined electro-optic modulator and deflector. In a preferred embodiment, the optical deflector is or comprises one or more acousto-optic modulators (AOMs, which may for example primarily be designed or used for modulation but may also cause deflection of a light beam), one or more acousto-optic deflectors (AODs) and/or one or more acousto-optic devices acting both as a deflector and as a modulator. For the sake of simplicity, the terms "acousto-optic modulator" and "acousto-optic modulator and/or deflector" may be used herein to refer to any one of an acousto-optic modulator, an acousto-optic deflector and a combined acousto-optic modulator and deflector. The acousto-optic modulator may be configured to deflect the light beam using soundwaves (e.g., radio-frequency sound waves), for example by diffraction induced by the acousto-optic effect. Scanning the light beam may for example comprise adjusting (e.g., scanning or ramping) a frequency of one or more control signals (e.g., a radio-frequency control signal) for the acousto-optic modulators for generating the sound waves. By adjusting the frequency of a control signal (and thereby of the sound waves generated by the respective acousto-optic modulator), a deflection angle of the light beam at the respective acousto-optic modulator may be adjusted. Using optical deflectors and in particular acousto-optic modulators may allow for rapidly scanning the light beam across the plurality of probing positions.

As mentioned above, the probing positions may be spatially separated from each other. The probing positions may for example be arranged in a one-dimensional or two-dimensional array, in particular a one-dimensional or two-dimensional periodic array (e.g., a rectangular array). In some examples, the probing positions may be positions (e.g., within the sensing area of a substrate as described below) that have been found to exhibit good sensing properties (e.g., large spin-lattice and/or spin-spin relaxation times), wherein such "good" probing positions may for example be distributed (more or less) randomly (i.e., the array may be an irregular or "random" array in such cases). Additionally or alternatively, a spacing between adjacent probing positions may be larger than a diameter (e.g., a 1/e² diameter or a full width at half maximum, FWHM) of the focused light beam (at the probing positions), in some examples larger than two times, in some examples larger than five times, in one example larger than ten times the diameter of the focused light beam. This may for example allow for illuminating each of the probing positions individually without illuminating any of the other probing positions. In other examples, the spacing between adjacent probing positions may be smaller than the diameter of the focused light beam, in some examples smaller than 50%, in some examples smaller than 20%, in one example smaller than 10% the diameter of the focused light beam. This may for example be advantageous for achieving more homogeneous illumination intensities, e.g., a more homogeneous photon count per unit area.

In addition to illuminating solid-state spin systems at the probing positions by scanning the focused light beam, the method according to the invention may comprise further steps associated with preparing, manipulating and/or probing the solid-state spin systems, e.g., a state and in particular spin state thereof.

The method may for example comprise manipulating a spin state of solid-state spin systems at some or all of the probing positions using microwave and/or radio-frequency electromagnetic fields (e.g., microwave and/or radio-frequency electromagnetic radiation). For simplicity, only the term "microwave" is used in the following but it is to be noted that in some embodiments of the method and device according to the invention radio-frequency electromagnetic fields may be used instead of or in addition to microwave electromagnetic fields, e.g., depending on the level structure of the solid-state spin systems used. In contrast to the sequential illumination, the microwave manipulation may be performed at two or more, in some examples at all of the probing positions simultaneously, e.g., using a single microwave applicator applying the microwave electromagnetic fields at all of the respective probing positions simultaneously. The microwave manipulation may comprise applying one or more microwave pulses, e.g., one or more π/2 pulses and/or one or more π pulses, for example one or more pulse sequences as commonly used for NMR spectroscopy and/or ESR spectroscopy. The manipulation of the spin state of the solid-state spin systems may for example be performed as part of a measurement sequence as described below. Simultaneous manipulation of the spin state of the solid-state spin systems in combination with fast sequential scanning of the focused light beam (e.g., for optical read-out) may reduce the duration of measurements and thus, e.g., allow for quickly repeating measurements to perform large numbers of measurements even when using long pulse sequences as in advanced NMR sensing schemes. Furthermore, a more uniform manipulation across the plurality of probing positions may be achieved.

In some examples, the method may comprise initializing solid-state spin systems at the plurality of probing positions in an initial state, e.g., in a particular electronic and/or spin state of the solid-state spin systems. The solid-state spin systems may for example be initialized in the initial state by optical illumination, e.g., by optical polarization or optical pumping. In some examples, this may comprise sequentially scanning a focused light beam across said plurality of probing positions as described above. In other examples, the solid-state spin systems may be initialized simultaneously, e.g., by uniform illumination.

After initializing the solid-state spin systems in the initial state, the method may further comprise performing a measurement sequence on the solid-state spin systems at the plurality of probing positions. The measurement sequence may be performed prior to sequentially scanning the focused light beam across the plurality of probing positions, wherein the latter may for example be performed for optical read-out of the state of the solid-state spin systems at the end of the measurement sequence (i.e., the measurement sequence may be performed between (e.g., optical) initialization and optical read-out of the state of the solid-state spin systems). In some examples, the state of the solid-state spin systems may evolve coherently during the measurement sequence, starting out from the initial state. The measurement sequence may comprise one or both of a free evolution of the spin state of said solid-state spin systems and manipulating (e.g., coherently) the spin state of the solid-state spin systems using microwave (and/or radio-frequency) electromagnetic fields. In one example, the measurement sequence comprises manipulating the spin state of the solid-state spin systems using a first microwave pulse sequence, followed by a free evolution and, optionally, a second microwave pulse sequence (e.g., for spin echo or dynamical decoupling). During the free evolution, the state of the solid-state spin systems may evolve freely under the influence of the environment of the respective solid-state spin system (e.g., under the influence of a respective sample arranged adjacent thereto and/or under the influence of the surrounding host material) but without active external manipulation, e.g., without applying any external optical, microwave and/or radio-frequency electromagnetic fields. The (active) manipulation of the spin state of the solid-state spin systems by microwave electromagnetic fields may for example be performed as described above and in particular simultaneously at two or more, preferably all of the probing positions. Preferably, the sequential scanning of the focused light beam is performed immediately after the end of the measurement sequence, e.g., immediately after the last microwave pulse of the measurement sequence or immediately after the end of the free evolution.

In a preferred embodiment, the scanning duration is shorter, in some examples substantially shorter (e.g., as described above) than one or both of a measurement duration of the measurement sequence and a free evolution period (or duration) of the free evolution of the spin state of the solid-state spin systems. Performing the sequential scanning of the focused light beam (e.g., for optical read-out) faster than the measurement sequence and/or the free evolution may allow for achieving higher sensitivity and/or lower signal-to-noise ratio, for example by reducing information loss during the sequential scanning and/or allowing for faster repetitions of measurements. The measurement duration may for example be the time between the beginning of the earlier one of a first microwave pulse and a first free evolution of the measurement sequence and the end of the later one of a last microwave pulse and a last free evolution of the measurement sequence. In embodiments where the sequential scanning of the focused light beam is performed immediately after the end of the measurement sequence, the measurement duration may for example be the time between the end of the initialization of the solid-state spin systems in the initial state and the illumination of solid-state spin systems at the first probing position as part of the sequential scanning of the focused light beam. The measurement duration may be shorter than one or both of the spin-lattice and spin-spin relaxation times. The free evolution period may for example be an interaction period or time during which the solid-state spin systems interact freely with their environment, e.g. after the first microwave pulse sequence or between the first and second microwave pulse sequences.

Additionally or alternatively, the method may for example comprise, for some or all probing positions, detecting light emitted by the solid-state spin systems at the respective probing position upon illumination with the focused light beam using a photodetector, in particular a same photodetector (e.g., for optical read-out of the state of the solid-state spin systems). Preferably, the photodetector is a point-like photodetector, i.e., a spatially non-resolving photodetector, which for example measures a single light intensity (e.g., a light intensity at a single measurement point or an aggregated light intensity over a single detection region). The photodetector may for example be a photodiode, in particular an avalanche photodiode (APD), or a photomultiplier (e.g., a photomultiplier tube). In some examples, the photodetector may be a single-photon detector such as, for example, a single-photon avalanche diode (SPAD) or a superconducting nanowire single photon detector (SNSPD). In other samples, a spatially resolving photodetector may be used instead, for example a CCD or CMOS sensor or a photodiode array (e.g., an APD array). In some examples, the method may further comprise obtaining information pertaining to a state, in particular a spin state of the solid-state spin systems at the respective probing position based on the detected light, e.g., based on an intensity thereof.

The method may further comprise associating intensities of the light detected at different points in time (e.g., by said point-like photodetector) with a respective one of said plurality of probing positions based on a scan order (e.g., a scan path) of the focused light beam across the plurality of probing positions. As a result of the sequential illumination of the probing positions, the solid-state spin systems at different probing positions also emit light at different points in time (namely in the same temporal order in which the probing positions are illuminated). Put differently, spatial information pertaining to the origin of the detected light (e.g., which probing position the light originates from) may be encoded as temporal information in the intensity measured by the photodetector (e.g., at which point in time during the scanning duration the respective intensity value is measured). Even when using a spatially non-resolving photodetector, this may allow for distinguishing the probing positions from each other, for example to reconstruct a spatial map (e.g., a one-dimensional or two-dimensional spatial map) of the detected light intensity. In other words, spatially resolved information may be obtained without requiring spatially resolving photodetectors, which typically are less sensitive than point-like photodetectors.

As mentioned above, some or all of the probing positions (also referred to as "sample probing positions" in the following) may be adjacent to a sample to be probed using the solid-state spin systems, e.g., within a sufficiently small distance that allows for interaction between the sample and the solid-state spin systems at the respective probing position and thus for probing of the sample via the solid-state spin systems. A distance between the sample probing positions and the sample may for example be smaller than 500 µm, in some examples smaller than 100 µm, in some examples smaller than 20 µm, in one example smaller than 10 µm and in one example smaller than 5 µm, e.g., for micrometer-scale sensing with thermal polarization of the solid-state spin systems. In other examples, e.g., for nanometer-scale sensing with statistical polarization of the solid-state spin systems, the distance between the sample probing positions and the sample may be smaller than 1 µm, in some examples in some examples smaller than 100 nm and in some examples smaller than 10 nm. Each of the sample probing positions may be adjacent to a respective sample (e.g., each of the samples may be arranged adjacent to a different one of the sample probing positions). In other examples, two or more sample probing positions, in some examples all sample probing positions, may be adjacent to a same sample, e.g., adjacent to different portions thereof. In yet other examples, as mentioned above, the solid-state spin systems themselves and/or the surrounding host material at the probing positions may be the "sample(s)" to be probed, i.e., no other sample may be placed adjacent to the probing positions.

In some examples, one or more of the probing positions (also referred to as "reference probing positions" in the following) may not be adjacent to any sample to be probed using the solid-state spin systems, e.g., arranged at a sufficiently large distance such that interactions between the sample and the solid-state spin systems at the respective probing position are negligible. The reference probing positions may for example be used for sample-independent reference measurements, for example to identify or compensate for effects external to the samples, e.g., effects resulting from the host material and/or an external environment and/or noise produced by electronic control and/or readout equipment. The one or more reference probing positions may for example be used for performing differential measurements. A distance between the reference probing positions and the respective closest sample may for example be at least 1 µm, in some examples at least 10 µm, in some examples 100 µm, in some examples at least 500 µm, in some examples at least 1 mm, in one example at least 2 mm and in one example at least 5 mm. Additionally or alternatively, the distance between the reference probing positions and the respective closest sample may, e.g., be at least 2 times larger, in some examples at least 3 times larger, in some examples at least 5 times larger, in one example at least 10 times larger and in one example at least 100 times larger than a distance (e.g., an average distance) between the sample probing positions and the respective closest sample

The present invention further provides a device for probing optically addressable solid-state spin systems. The device comprises a substrate comprising a plurality of optically addressable solid-state spin systems arranged in a sensing area within the substrate. The device further comprises an illumination system configured to direct a light beam onto an illumination spot in the sensing area for optically exciting solid-state spin systems within the illumination spot. The illumination system comprises an optical deflector configured to deflect the light beam for laterally moving the illumination spot across the sensing area. The illumination system is configured to move the illumination spot across a lateral extent of the sensing area within three times a spin-lattice relaxation time of the solid-state spin systems and/or within three times a spin-spin relaxation time of the solid-state spin systems.

The device may be configured for probing the solid-state spin systems using a method for probing optically addressable solid-state spin systems at a plurality of probing positions according to any one of the embodiments disclosed herein. In some examples, the device may be configured for probing one or more samples using the solid-state spin systems, e.g., as detailed below. In other examples, the solid-state spin systems themselves may be the "samples" to be probed.

The substrate may comprise or consist of a host material in which the solid-state spin systems are embedded. The substrate may for example be provided as a chip or a slab of material. The sensing area may correspond to the portion of the substrate in which solid-state spin systems are arranged (i.e., the solid-state spin systems may be confined to the sensing area). In some examples, the sensing area may comprise the entire substrate, i.e., the solid-state spin systems may be arranged throughout the entire substrate. In other examples, the sensing area may be confined to a part of the substrate, for example laterally to a central portion thereof or vertically to a particular layer thereof (e.g., a surface layer or a layer adjacent to a surface of the substrate). The solid-state spin systems may be distributed throughout the sensing area, in some examples homogeneously. In other examples, the solid-state spin system may be confined to spatially separated sensing regions within the sensing area, wherein the sensing regions may, e.g., be arranged in a one-dimensional or two-dimensional array and/or below a respective sample site for arranging a sample. In some examples, some or all of the solid-state spin systems within the sensing area may be arranged at a distance (depth) from a surface of the substrate (e.g., the sampling surface as described below) so as to enable interaction with one or more samples arranged thereon. The solid-state spin systems may for example be arranged at a depth between 0 µm and 500 µm, in some examples between 0 µm and 100 µm, in some examples between 0 µm and 20 µm, in some examples between 0 µm and 10 µm, in some examples between 0 µm and 5 µm, in some examples between 0 µm and 2 µm below the surface, e.g., for micrometer-scale sensing with thermal polarization of the solid-state spin systems. In other examples, e.g., for nanometer-scale sensing with statistical polarization of the solid-state spin systems, the solid-state spin systems may be arranged at a depth between 0 µm and 1 µm, in some examples between 0 nm and 200 nm, in some examples between 0 nm and 100 nm, in some examples between 0 nm and 50 nm, in one example between 0 nm and 20 nm and in one example between 0 nm and 10 nm below the surface. In other examples, e.g., where the solid-state spin systems themselves are the samples to be probed, the solid-state spin systems may be arranged in the bulk of the substrate, e.g., at larger depths and in some examples over the entire thickness of the substrate.

In some examples, the device according to the invention may also comprise multiple substrates as described herein, which may, e.g., be arranged at different positions around a large sample (e.g., a patient's brain). The illumination system may be configured to move the illumination spot across the lateral extents of the sensing areas of some or all of the substrates within three times the spin-lattice relaxation time of said solid-state spin systems, in some examples within the spin-lattice relaxation time, and/or within three times the spin-spin relaxation time of said solid-state spin systems, in some examples within the spin-spin relaxation time. Additionally or alternatively, the illumination system may be configured to direct a respective light beam (of a plurality of light beams) onto an illumination spot in the sensing area for each of the substrates (or for each of a subset of substrates) and to scan each of these illumination spots across the lateral extent of the respective sensing area(s) within three times the spin-lattice relaxation time and/or within three times the spin-spin-relaxation time, in some examples within the spin-lattice relaxation time and/or within the spin-spin-relaxation time.

The solid-state spin systems may for example be or comprise the solid-state spin systems mentioned above for the method according to the invention. In a preferred embodiment, the solid-state spin systems are or comprise diamond color centers, in particular nitrogen-vacancy centers (NV centers), spin defects in a van-der-Waals material, and/or spin defects in a semiconductor material, in particular spin defects in silicon carbide. Accordingly, the substrate or a part thereof (in particular the sensing area) may comprise or consist of suitable host material such as for example diamond, a van-der-Waals material such as graphite, hexagonal boron nitride (hBN), and transition metal dichalgonites (TMD) such as molybdenum disulfide (MoS₂), and/or a semiconductor material such as silicon carbide (SiC).

The illumination system may be configured to receive the light beam from a light source, preferably a monochromatic light source, such as a laser or a light-emitting diode (LED), wherein the light source may be comprised in the device (e.g., in the illumination system) according to the invention or external to said device (e.g., provided as a separate unit). The illumination system may be configured to focus the light beam onto the illumination spot in the sensing area or in the vicinity thereof (i.e., slightly in front of or behind the illumination spot/sensing area along the direction of propagation of the light beam). For directing and/or focusing the light beam onto the illumination spot, the illumination system may comprise one or more optical elements such as mirrors and/or lenses. In some examples, the illumination system may be configured for use with a plurality of light sources, e.g., to receive a light beam of each of a plurality of light sources and direct the respective light beam onto an illumination spot in the sensing area as described herein.

The illumination system is configured to move the illumination spot across a lateral extent of the sensing area (e.g., an in-plane extent perpendicular to a thickness direction (e.g., the direction of smallest extent) of the sensing area or the substrate and/or an extent parallel to a surface of the substrate or sensing area, in particular a primary surface of the substrate or sensing area having the largest surface area of the surfaces of the substrate and sensing area, respectively) within three times the spin-lattice relaxation time and/or within three times the spin-spin relaxation time of the solid-state spin systems. In some examples, the illumination system is configured to move the illumination spot across the lateral extent of the sensing area within two times the spin-lattice relaxation time and/or within two times the spin-spin relaxation time of the solid-state spin systems. Preferably, the illumination system is configured to move the illumination spot across the lateral extent of the sensing area within the spin-lattice relaxation time and/or within the spin-spin relaxation time of the solid-state spin systems. Most preferably, the illumination system is configured to move the illumination spot across the lateral extent of the sensing area within a small fraction of the spin-lattice relaxation time and/or of the spin-spin relaxation time, for example within less than 10%, in some examples less than 5%, in some examples less than 2%, in one example less than 1% and in one example less than 0.1% of the spin-lattice relaxation time and/or of the spin-spin relaxation time. This may for example allow for performing two-dimensional scans laterally across the sensing area within three times the spin-lattice and/or three times spin-spin relaxation times, in some examples within the spin-lattice and/or spin-spin relaxation times or fractions thereof, e.g., as used in the method according to the invention. For example, if the illumination system is configured to move the illumination spot across the lateral extent of the sensing area within less than 10% of the spin-lattice or spin-spin relaxation time, the illumination spot may be scanned 10 times (e.g., along ten rows or columns of a probing position array) across the lateral extent of the sensing area within the spin-lattice and spin-spin relaxation time, respectively. The spin-lattice and spin-spin relaxation times may, e.g., be within the ranges given above for the method according to the invention. The lateral extent of the sensing area may for example be a width or a length of the sensing area and may, e.g., be measured parallel to a surface of the substrate such as the sampling surface described below (with a thickness of the sensing area being measured perpendicular to the surface). The illumination system may be configured to move the illumination spot along one or two lateral directions, e.g., two orthogonal lateral directions, for example across a width and a length of the sensing area. The illumination system may in particular be configured to move the illumination spot across two orthogonal lateral extents (e.g., a width and a length) of the sensing area, each or both within three times the spin-lattice relaxation time and/or three times the spin-spin relaxation time, in some examples each or both within the spin-lattice relaxation time and/or the spin-spin relaxation time or one of the aforementioned fractions thereof. Preferably, the illumination system is configured to move the illumination spot across the sensing area as described above for the method according to the invention, e.g., sequentially across a plurality of probing positions within the sensing area (for example along a predefined one-dimensional or two-dimensional scan path within the sensing area). As mentioned above, the scan path is not particularly limited but may be any one- or two-dimensional line geometry (i.e., of arbitrary shape). This may for example allow for selectively addressing certain probing positions within the sensing area, which for example may have been found to exhibit good sensing properties (e.g., large spin-lattice and/or spin-spin relaxation times). Such "good" probing positions may for example be distributed randomly throughout the sensing area.

For laterally moving the illumination spot across the sensing area, the illumination system comprises an optical deflector that is configured to deflect the light beam, e.g., by an adjustable angle and/or an adjustable parallel displacement. Put differently, the optical deflector may be configured to adjust a propagation axis or direction of the light beam so as to move the point at which the light beam intersects with the sensing area, which may define the illumination spot (i.e., the region of the sensing area illuminated by the light beam). The optical deflector may not comprise any movable parts but may for example be configured to achieve a deflection of the light beam using electrical and/or acoustical signals (e.g., fields or waves). Preferably, the optical deflector is or comprises one or more acousto-optic modulators and/or deflectors configured to deflect the light beam along one or two directions, for example a single-axis acousto-optic modulator, a pair of single-axis acousto-optic modulators (which may, e.g., be oriented perpendicular to each other) or a dual-axis acousto-optic modulator. Additionally or alternatively, the optical deflector may for example also comprise one or more electro-optic modulators and/or deflectors.

In some examples, the device may be configured for probing a sample using optically addressable solid-state spin systems. The substrate may for example comprise a sampling surface for arranging one or more samples thereon and said sensing area may be a sensing layer below said sampling surface. The sample (or samples) is not particularly limited and may be a liquid and/or solid sample. As used herein, the term "sample" may refer to samples other than the solid-state spin systems themselves and the surrounding host material (e.g., samples separate from or arranged outside of the sensing area of the substrate). The sample may for example be or comprise a solid sample object (e.g., a biological sample object such as a cell or a protein) or a microdroplet of a sample fluid. The sample fluid may, e.g., be or comprise a medical sample fluid such as a blood sample, a chemical sample fluid comprising one or more reagents and/or products of a chemical reaction, and/or a biological sample fluid, which may e.g., comprise one or more biological objects such as cells, proteins or DNA. In some examples, the sample may, e.g., be provided as a surface layer or coating on the sampling surface, e.g., a mono- or multilayer of molecules to be probed or a single layer, multilayer or stacked sample comprising one or more layers of a 2D material (e.g., a van der Waals material). Said one or more layers of the 2D material may for example have a different crystal orientation or the same crystal orientation as the substrate (e.g., the sensing area/layer) and/or maybe composed of the same or a different material than the substrate (e.g., the sensing area/layer). In some examples, the device may be configured to probe a plurality of samples in parallel, e.g., by arranging the plurality of sample on the sampling surface, for example in a one-dimensional or two-dimensional array.

In some examples, the sampling surface may comprise one or more sample sites configured to receive a respective sample. Each of the sample sites may be configured to confine (e.g., hold in place) the respective sample on the sampling surface. For this, each of the sample sites may for example comprise structural features such as one or more protrusions and/or one or more recesses on the sampling surface and/or one or more hydrophilic and/or hydrophobic coatings on the sampling surface. In some examples, the sample sites may be microfluidic sample wells. In other examples, the sampling surface (or at least part thereof) may be a flat surface without any pre-defined sample sites and/or structural features.

The sensing layer may be a surface layer forming the sampling surface or a part thereof. In other examples, one or more additional layers may be arranged between the sensing layer and the sampling surface, for example one or more optical coatings and/or one or more hydrophilic and/or hydrophobic coatings. Additionally or alternatively, one or more functional layers (surface-chemistry layers) may be arranged between the sensing layer and the sampling surface, wherein said functional layers may for example serve to improve sensing capabilities of the solid-state spin systems, e.g., increase the spin-lattice and/or spin-spin relaxation times, reduce noise and/or improve charge state stability.

In some examples, the illumination system may be configured to direct the light beam onto the illumination spot in the sensing area such that the light beam is reflected at a surface of the sensing area or of the substrate, for example by total internal reflection. The illumination system may in particular be configured to direct the light beam onto the illumination spot in the sensing layer such that the light beam is reflected at the sampling surface and/or at a surface of the sensing layer (e.g., a surface of the sensing layer facing the sampling surface), for example by total internal reflection. For this, the illumination system may, e.g., be configured to adjust an angle of incidence of the light beam at the respective surface accordingly. This may for example prevent the light beam from reaching the sample(s).

The device may further comprise additional components for preparing, manipulating and/or probing the solid-state spin systems, e.g., a state and in particular spin state thereof. The device may for example comprise a microwave and/or radio-frequency applicator (referred to as microwave applicator in the following), in particular a microwave and/or radio-frequency antenna and/or a microwave and/or radio-frequency resonator, for applying microwave and/or radio-frequency electromagnetic fields (e.g., microwave and/or radio-frequency radiation) to the solid-state spin systems in the sensing area, in particular simultaneously to all solid-state spin systems in the sensing area. The microwave applicator may for example be a microwave stripline. Preferably, the microwave applicator is configured to apply the microwave (and/or radio-frequency) electromagnetic fields homogenously to the solid-state spin systems in the sensing area (e.g., throughout the entire sensing area), for example such that an amplitude or an intensity of the microwave electromagnetic field varies by less than 30%, in some examples by less than 20%, preferably by less than 10%, most preferably by less than 5%, in one example by less than 2% and in one example by less than 1% between the solid-state spin systems in the sensing area (e.g., throughout the entire sensing area and/or substrate). Improved field homogeneity may allow for performing longer pulse sequences, e.g., as used in advanced NMR sensing schemes.

In some examples, the device may also comprise a microwave (and/or radio-frequency) generator (referred to as microwave generator in the following) configured to generate a microwave (and/or radio-frequency) signal. In other examples, the device may be configured for use with an external microwave generator. The (internal or external) microwave generator may be configured to provide the microwave signal to (e.g., couple the microwave signal into) the microwave applicator. The microwave signal may comprise one or more microwave pulses, e.g., as described above for the method according to the invention.

The device may comprise a photodetector for detecting light emitted by the solid-state spin systems in the sensing area. Preferably, the photodetector is a point-like photodetector (i.e., a spatially non-resolving photodetector) such as a photodiode, in particular an avalanche photodiode, a photomultiplier and/or a single-photon detector as described above. In other examples, the photodetector may also be a spatially resolving photodetector and may, e.g., be or comprise a CCD or CMOS chip or camera or a photodiode array. The device may further comprise an imaging system for imaging light emitted by the solid-state spin systems in the sensing area onto the photodetector, e.g., to focus light emitted by the solid-state spin system throughout the sensing area onto a same point-like photodetector (i.e., image the entire sensing area onto the photodetector).

In some examples, the device may also comprise one or more light sources, in particular one or more monochromatic light sources, configured to generate the light beam, for example one or more lasers and/or one or more light-emitting diodes. In other examples, the device may be configured for use with one or more external light sources, e.g., by providing a light beam generated by the external light source to the illumination system (e.g., coupling the light beam into the illumination system). The (internal or external) light source may be configured to generate light with one or more wavelengths adapted to an energy spectrum of the solid-state spin systems, e.g., resonant with or slightly detuned from a respective transition between two states of the solid-state-spin systems.

The device may be configured to execute some or all steps of the method for probing optically addressable solid-state spin systems according to any one of the embodiments disclosed therein. For this, the device may comprise a controller configured to execute the respective steps by controlling one or more of the illumination system, the photodetector, the imaging system, the (internal or external) light source(s) and the (internal or external) microwave generator. The controller may be implemented in hardware, software or a combination thereof. The controller may for example comprise a processor and a memory storing instructions for execution by the processor to provide the respective functionality.

In some examples, the device according to any one of the embodiments disclosed herein may also be provided without the substrate comprising the sampling surface and the sensing area with the solid-state spin systems but may be configured for use with a corresponding substrate (e.g., to be provided by a user of the device). The device may for example comprise a mount to receive the substrate within an accommodation volume and position the substrate relative to the illumination system. When the substrate is received in the mount, the illumination system may be configured to direct the light beam onto an illumination spot in the sensing area of the substrate and laterally move the illumination spot across the sensing area, e.g., as described above. The illumination system may for example be configured to laterally move the illumination spot across a lateral extent of the accommodation volume (which may, e.g., correspond to a lateral extent (e.g., a maximum lateral extent) of the sensing area or substrate to be arranged in the accommodation volume) within less than 1 ms, preferably within less than 100 µs, most preferably within less than 20 µs, in one example within less than 10 µs and in one example within less than 1 µs. Additionally or alternatively, the illumination system may be configured to laterally move the illumination spot within the accommodation volume with a scanning velocity of between 10⁻⁴ mm/µs and 10² mm/µs, in some examples of between 10⁻³ mm/µs and 10² mm/µs, in some examples between 10⁻² mm/µs and 10 mm/µs and in some examples between 0.1 mm/µs and 10 mm/µs.

### LIST OF FIGURES

In the following, a detailed description of the invention and exemplary embodiments thereof is given with reference to the figures. The figures show schematic illustrations of
Fig. 1: a device for probing optically addressable solid-state spin systems according to an example in side view;
Fig. 2: a flow diagram of a method for probing optically addressable solid-state spin systems at a plurality of probing positions in accordance with an example;
Fig. 3: a device for probing optically addressable solid-state spin systems according to another example in top view;
Fig. 4: a device for probing optically addressable solid-state spin systems according to another example in side view;
Fig. 5: a flow diagram of a method for probing optically addressable solid-state spin systems at a plurality of probing positions in accordance with another example; and
Fig. 6: exemplary microwave and illumination pulse sequences for the method of Fig. 5.

### DESCRIPTION OF THE PREFERRED EMBODIMENTS

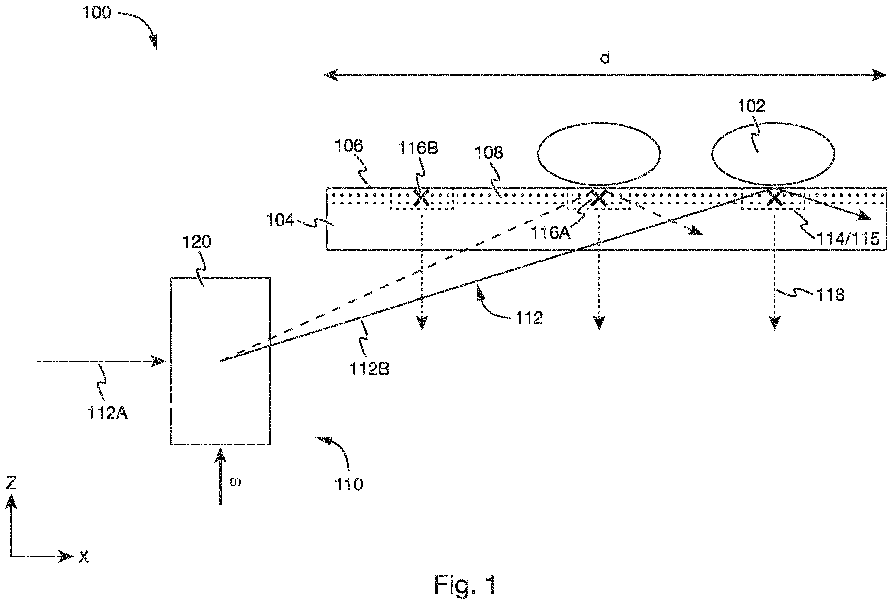

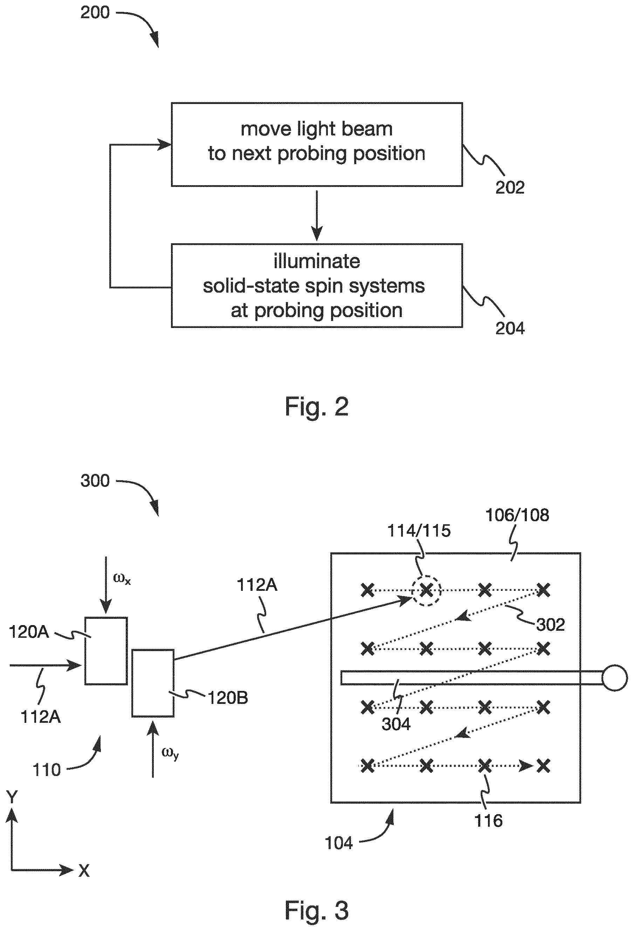

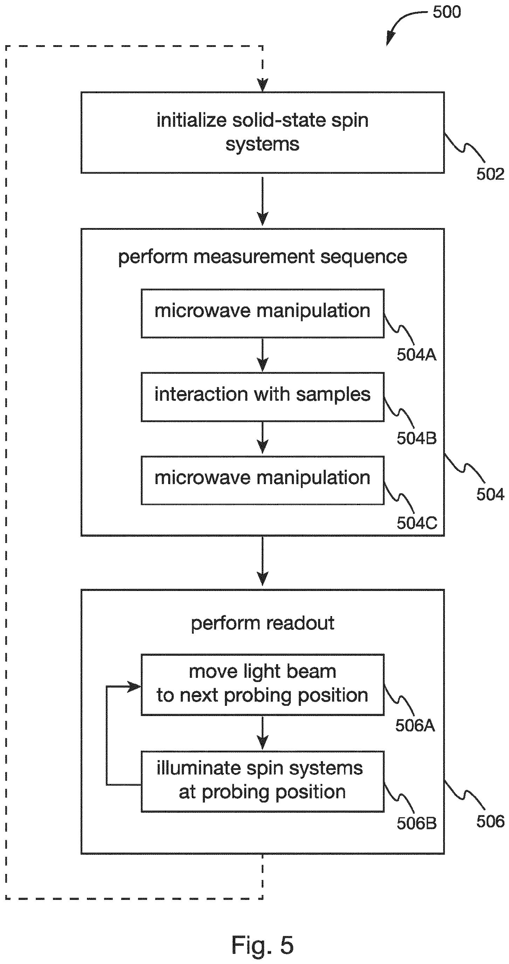

Fig. 1 depicts a schematic illustration of a device 100 for probing optically addressable solid-state spin systems according to an example in side view (not to scale). The device 100 may for example be used for executing (in some examples configured to execute some or all steps of) a method for probing optically addressable solid-state spin systems according to any one of the embodiments described herein, for example one or both of method 200 of Fig. 2 and method 500 of Fig. 5 described below. The device 100, as in the example of Fig. 1, may for example be used for probing one or more samples 102 (referred to as samples 102 in the following) using optically addressable solid-state spin systems as probes. In other examples, the solid-state spin systems themselves or the surrounding host material may, e.g., be the "samples" to be probed.

The device comprises a substrate 104 comprising a sampling surface 106 (which may also be referred to as the top surface of the substrate 104 in the following) for arranging the samples 102 thereon. The substrate 104 may be a single-layer or multi-layer substrate and may for example comprise or consist of a suitable host material for solid-state spin systems such as diamond or a van-der-Waals material such as hexagonal boron nitride (hBN). In some examples, the substrate 104 may be embodied as a microfluidic chip. In some examples, e.g., where the solid-state spin systems themselves or the surrounding host material are the "samples" to be probed, the substrate 104 may not comprise a dedicated sampling surface.

In the example of Fig. 1, the samples 102 are microdroplets, which may, e.g., contain a chemical sample fluid comprising one or more reagents and/or products of a chemical reaction and/or a biological sample fluid comprising one or more biological objects such as cells, proteins or DNA. In other examples, some or all of the samples 102 may also be solid samples, which in some examples may be provided as a surface coating on the sample surface 106, e.g., a mono- or multilayer of molecules that are to be probed. In some examples, a single larger sample (or a few larger samples) may be used which is to be probed at different positions or spots (put differently, different portions of a same sample may constitute the "samples 102" to be probed). In one example, a single sample covers the entire sampling surface 106.

The sampling surface 106 may be a flat surface as illustrated in Fig. 1. In some examples, the sampling surface 106 may comprise additional structural features (not shown) for confining the samples 102 thereon (e.g., to define sample sites for arranging the samples 102 thereon or therein), for example one or more microfluidic sample wells, one or more hydrophobic and/or hydrophilic coatings, and/or boundary or guiding structures as for example described in WO 2022/243281 A1. The substrate 104 may for example be embodied as a sensor chip as disclosed in WO 2022/243281 A1.

In some examples, the substrate 104 may comprise one or more optical coatings (not shown), e.g., on or below the sampling surface 106 and/or on or above a bottom surface (back surface) of the substrate 104 opposite to the sampling surface 106. The one or more optical coatings may for example be or comprise a broadband reflective coating configured to reflect light at one or more absorption wavelength and at one or more emission wavelengths of the solid-state spin systems (e.g., on or below the sampling surface 106) and/or a dichroic reflective coating configured to reflect light at one or more absorption wavelengths of the solid-state spin systems and to transmit light at one or more emission wavelengths of the solid-state spin systems (e.g., on or above the bottom surface). In some examples, the substrate may also comprise a light guiding system as for example described in WO 2021/219516 A1. In some examples, the substrate 104 may comprise a plurality of solid immersion lenses (not shown) and/or a plurality of nanopillars on the top surface and/or on the bottom surface, which may, e.g., be arranged below a respective one of the sample sites, sensing regions 115 and/or probing positions 116 described below).

Additionally or alternatively, one or more functional layers (surface chemistry layers, not shown) may be arranged on or below the sampling surface 106. The functional layers may for example serve to improve sensing capabilities of the solid-state spin systems in the sensing layer 108, e.g., increase the spin-lattice and/or spin-spin relaxation times, reduce noise and/or improve charge state stability.

For probing the samples 102, the substrate 104 comprises a sensing area 108, in the example of Fig. 1 a sensing layer 108, in which a plurality of optically addressable solid-state spin systems is arranged (e.g., embedded). The sensing layer 108 may comprise or consist of a suitable host material such as diamond or a van-der-Waals material such as hexagonal boron nitride (hBN) and the solid-state spin systems may for example be diamond color centers, in particular nitrogen-vacancy centers (NV centers), and spin defects in the van-der-Waals material, respectively. The solid-state spin systems may be distributed throughout the sensing layer as illustrated in Fig. 1 or may be confined to spatially separated sensing regions (referred to as pre-defined sensing regions in the following). The latter may, e.g., be arranged and shaped similar to the "illumination-defined" sensing regions 115 defined by the illumination spot 114 illustrated in Fig. 1. A density of the spin system in the sensing layer 108 or the pre-defined sensing regions may for example be between 10¹⁵ cm⁻³ and 10¹⁸ cm⁻³, in one example between 10¹⁶ cm⁻³ and 10¹⁷ cm⁻³.

In one example, the solid-state quantum systems are diamond NV centers in a negative charge state, which exhibits a triplet electronic ground state with a spin of S = 1. The spin state of these NV centers may be manipulated using microwaves and may be readout (e.g. through spin-dependent fluorescence in the excited state) and/or initialized via optical transitions to an excited triplet state. This, e.g., allows for using NV centers as nanoscale magnetometers for measuring magnetic fields, for example through optically detected magnetic resonances (ODMR).

The sensing layer 108 is arranged below the sampling surface 106 and in some examples may form the sampling surface 106 or a part thereof. The sensing layer 108 may extent laterally (e.g., parallel to the sample surface) across the entire substrate or a part thereof. The sensing layer 108 has a lateral extent (e.g., a width) d, which may for example be between 50 µm and 50 mm, in some examples between 100 µm and 10 mm, in one example between 200 µm and 5 mm. A distance between the sensing layer 108 (e.g., a top surface or interface thereof, a center thereof or a bottom surface or interface thereof) and the sampling surface 106 may be chosen so as to allow for sufficiently strong interaction between some or all solid-state spin systems in the sensing layer 108 and the samples 102. The distance may for example be between 0 µm and 100 µm, in some examples between 0 µm and 10 µm, in some examples between 0 µm and 1 µm. The sensing layer 108 may extend across the entire thickness of the substrate 104 (measured along the Z direction of Fig. 1) or may be confined to an upper portion thereof. A thickness of the sensing layer 108 may for example be with the aforementioned ranges for the distance between the sensing layer 108 and the sampling surface 106. In other examples, the sensing area may take different forms and in particular does not necessarily have to be a planar layer as illustrated in Fig. 1. The solid-state spin systems may be arranged in the bulk of the substrate 104, in particular in examples where the solid-state spin systems themselves are the "samples" to be probed. The sensing area (or the sensing layer) may comprise the entire substrate 104 in some examples, i.e., the solid-state spin systems may be arranged throughout the substrate 104.

The device 100 further comprises an illumination system 110 for illuminating the solid-state spin systems in the sensing layer 108 (as an example of a sensing area). For this, the illumination system 110 is configured to direct a light beam 112, in particular a focused light beam, onto an illumination spot 114 in the sensing layer 108. The illumination spot 114 may define a sensing region 115 ("illumination-defined" sensing region) within the (e.g., uniform) sensing layer 108 (i.e., a region within which solid-state spin systems are illuminated) and/or may illuminate a pre-defined (structurally defined) sensing region within the sensing layer (e.g., one of a plurality of spatially separated sensing regions to which the solid-state spin systems are confined). In the example of Fig. 1, the illumination system 110 is configured to direct the light beam 112 onto the illumination spot 114 such that the light beam 112 is reflected at the sampling surface 106 by total internal reflection.

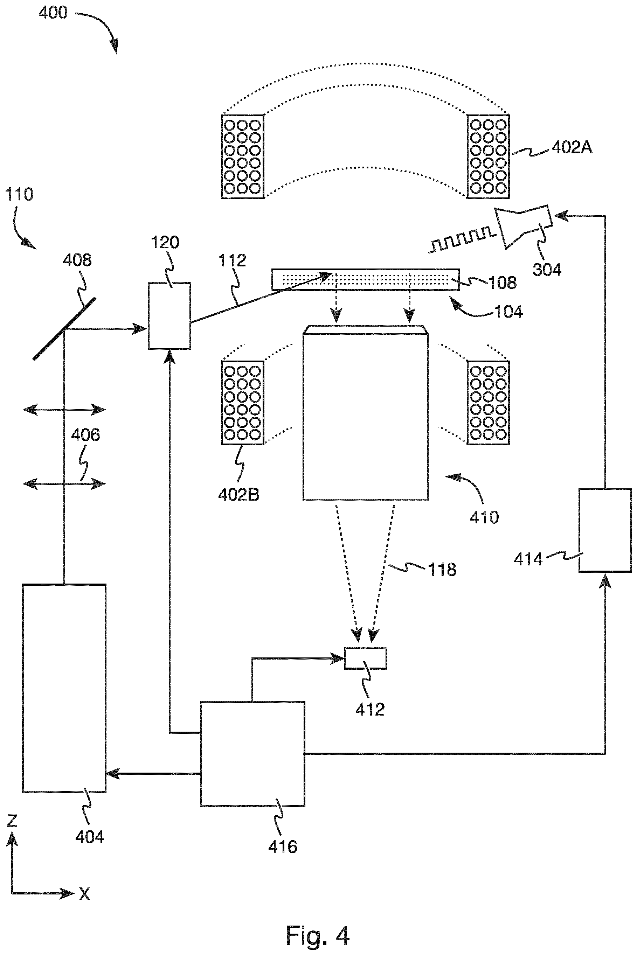

The illumination system 110 is configured to move the illumination spot 114 laterally across the sensing layer 108, i.e., in one or two directions perpendicular to a thickness direction thereof (corresponding to the Z direction of Fig. 1), i.e., parallel to the sampling surface 106 in the example of Fig. 1 (e.g., along the X direction). The illumination system 110 may in particular be configured to move the illumination spot 114 to a respective one of a plurality of probing positions 116 in or on the sensing layer 108, e.g., as detailed below for method 200. Upon illumination by the light beam 112, the solid-state spin systems within the illumination spot 114/sensing region 115 (e.g., at and in the vicinity of a probing position 116) may be excited optically and, in response, may emit light or luminescence 118, which may for example be detected using a photodetector, e.g., as detailed below for the device 400 of Fig. 4.

To move the illumination spot 114, the illumination system 110 comprises an optical deflector 120 that is configured to deflect (at least a part of) an incoming light beam 112A by an adjustable deflection angle to form a deflected light beam 112B. In the example of Fig. 1, the optical deflector is an acousto-optic modulator (e.g., a single-axis acousto-optic modulator) that is configured to receive a radio-frequency control signal (illustrated by the arrow labelled ω in Fig. 1) and generate a soundwave therefrom to diffract the incoming light beam 112A. The deflected light beam 112B may for example correspond to a first diffraction order (e.g., +1 or-1) of the light beam 112 after passing through the acousto-optic modulator 120. By adjusting the frequency ω of the control signal (also referred to as control frequency ω), the deflection angle of the deflected beam 112B may be controlled. The frequency ω may for example be between 20 MHz and 2 GHz, preferably between 50 MHz and 1 GHz, in some examples between 100 MHz and 500 MHz. The frequency ω may for example be adjusted within a range of ±10 MHz, in some examples ±20 MHz, in one example ±50 MHz and in one example ±100 MHz for moving the illumination spot 114 laterally across the sensing layer 108. A deflection angle of the deflected light beam 112B may depend on the control frequency ω such that a larger adjustment range and/or center frequency of the control frequency ω may offer a larger movement range and/or faster scanning speeds of the illumination spot 114.

Compared to mechanical deflectors involving the use of movable parts, optical deflectors such as acousto-optic modulators may offer substantially faster deflection velocities and response times. Using the optical deflector 120 thus allows for rapidly moving the illumination spot 114 laterally across the sensing layer 108, e.g., to scan the light beam 112 across the plurality of probing positions 116 by sequentially moving the illumination spot 114 to different probing positions 116 as illustrated by the solid and dashed light beam 112 in Fig. 1. In particular, the illumination system 110 is configured to move the illumination spot 114 across the entire lateral extent d of the sensing layer 108 (i.e., from the left border of the sensing layer 108 to its right border in the example of Fig. 1) within three times a spin-lattice relaxation time (i.e., < 3 * T1) of said solid-state spin systems, in some examples within the spin-lattice relaxation time (i.e., < T1), and/or within three times a spin-spin relaxation time of said solid-state spin systems (i.e., < 3 * T2), preferably in some examples within the spin-spin relaxation time (i.e., < T2). Preferably, the illumination system 110 is configured to move the illumination spot 114 across the entire lateral extent d of the sensing layer 108 within a fraction of the spin-lattice and/or spin-spin relaxation times. While optical deflectors may provide smaller deflection angles and/or displacements than mechanical deflectors, this may be compensated for by an appropriate design of the optical path between the optical deflectors 120 and the sensing layer 108, for example by providing a sufficiently long propagation path for the deflected light beam 112 to achieve a sizeable deflection/displacement and/or by suitable optical magnification.

Fig. 2 shows a flow diagram of a method 200 for probing optically addressable solid-state spin systems at a plurality of probing positions in accordance with an example. The method 200 may for example be executed using a device for probing optically addressable solid-state spin systems according to any one of the embodiments disclosed herein such as the device 100 of Fig. 1, which is used as a non-limiting example for illustrative purposes in the following. The method 200 is used to illuminate solid-state spin system as part of a probing sequence for probing the solid-state spin systems (which may, e.g., serve to obtain information pertaining to a state that the solid-state spin systems are in), for example to manipulate a state of the solid-state spin systems by optical excitation (e.g., for initializing the solid-state spin systems in a particular initial state) and/or to readout a state of the solid-state spin systems by optical excitation.

The method 200 may in particular be used for probing one or more samples 102 (referred to as "samples" in the following respective of whether a single sample or multiple samples are probed) using the optically addressable solid-state spin systems as probes. In other examples, the solid-state spin systems in the sensing layer (or area) 108 themselves may be the "samples" to be probed, i.e., no external samples 102 may be arranged on the sampling surface 106. For probing the samples 102, each of the samples 102 may be arranged on the sampling surface 106 adjacent to one or more probing positions 116A in the sensing layer 108 (referred to as sample probing positions in the following), e.g., each sample 102 adjacent to a respective one of the probing positions 116 as illustrated in Fig. 1. In other examples, a plurality of sample probing positions 116A may be used for probing different portions of a same sample 102 by placing the sample 102 adjacent to the plurality of sample probing positions 116. In some examples, one or more of the probing positions 116 such as the leftmost probing position in Fig. 1 may be used as reference probing positions 116B with no sample 102 being arranged adjacent thereto, for example for performing differential measurements between the sample probing positions 116A and the reference probing positions 116B to compensate for influences external to the sample 102, for example effects associated with the substrate 104, the sensing layer 108 and/or an environment of or within the device 100 and/or the microwave control electronics and/or the detection electronics.

The method 200 comprises, at step 202, moving the light beam 112 to a first probing position 116 (e.g., the rightmost sample probing position 116A in Fig. 1) using the optical deflector 120, e.g., by moving the illumination spot 114 such that the illumination spot 114 encompasses the respective probing position (e.g., is aligned with or centered on the respective probing position). This may for example comprise adjusting the frequency ω of the control signal for the acousto-optic modulator 120 accordingly. While moving the light beam 112, the light beam 112 (e.g., the incoming light beam 112A and/or the deflected light beam 112B) may be switched off or blocked, e.g., to avoid illuminating solid-state spin systems away from the first probing position.

When the light beam 112 is at the first probing position 116 ("current probing position"), solid-state spin systems at the first probing position are illuminated with the light beam 112 in step 204, e.g., by generating a suitable light pulse. In some examples, the acousto-optic modulator 120 may be used for switching the light beam 112 (namely, the deflected light beam 112B) on and off (e.g., to generate the light pulse) and/or to control an intensity of the light beam 112 by adjusting the control signal accordingly. In some examples, step 204 may also comprise detecting light emitted by the solid-state spin systems at the first probing position 116 upon illumination using a photodetector, for example as described below for method 500 of Fig. 5.

Subsequently, the method 200 may return to step 202 for moving the light beam 112 to a second probing position 116 (e.g., the central sample probing positions 116A in Fig. 1 as illustrated by the dashed light beam) using the optical deflector 120 before illuminating solid-state spin systems at the second probing position with the light beam 112 in step 204, e.g. as described above for the first probing position 116. By repeatedly executing steps 202 and 204, the light beam 112 may be scanned sequentially across a plurality of probing positions 116 and, at each probing position 116, solid-state spin systems at the respective probing position 116 may be illuminated with the light beam 112.

The sequential scanning of an illumination by the light beam 112 in steps 202, 204 is performed such that the scanning duration within which the light beam 112 is scanned across the plurality of probing positions 116 (e.g., the duration between illuminating the first one and the last one of the plurality of probing positions) is shorter than three times a spin-lattice relaxation time (t_{sc} < 3 * T1), preferably shorter than the spin-lattice relaxation time (t_{sc} < T1), and/or shorter than three times a spin-spin relaxation time (t_{sc} < 3 * T2), preferably shorter than the spin-spin relaxation time (t_{sc} < T2), of the solid-state spin systems in the sensing layer 108, e.g., an average spin-lattice and/or spin-spin relaxation time of all solid-state spin systems in the sensing layer 108 or a subset thereof such as all solid-state spin systems within the illumination spot 114 / sensing regions 115.

Fig. 3 depicts another example of a device 300 for probing optically addressable solid-state spin systems in top view (not to scale). The device 300 is similar to the device 100 of Fig. 1 with corresponding elements being denoted by the same reference signs. In particular, the device 300 also comprises a substrate 104 with a sampling surface 106 and a sensing area or layer 108 comprising a plurality of solid-state spin systems.

The device 300 further comprises an illumination system 110 similar to the one of the device 100 with the exception that a pair of acousto-optic modulator 120A, 120B is used instead of the single acoustical-optic modulator 120 in the example of Fig. 1. The acousto-optic modulators 120A, 120B may for example be single-axis acousto-optic modulators which are oriented at an angle, in particular orthogonally to each other, for example such that the acousto-optic modulator 120A is configured to deflect the incoming light beam 112A along the Y direction of Fig. 3 (e.g., to move the illumination spot 114 in the sensing layer 108 along the Y direction) and the acousto-optic modulator 120B is configured to deflect the incoming light beam 112A along the Z direction (corresponding to the direction of view of Fig. 3), i.e., similar to the acousto-optic modulator 120 in Fig. 1 (e.g., to move the illumination spot 114 in the sensing layer 108 along the X direction). The acoustic-optic modulators 120A, 120B may be controlled independently using control signals with a respective control frequency ωₓ, ω_{y}. In other examples, a dual-axis acousto-optic modulator may be used instead of the pair of acoustical-optic modulators 120A, 120B in Fig. 3.

Using the pair of acousto-optic modulator 120A, 120B, the illumination spot 114 in the sensing layer 108 may be moved along two directions. This for example allows for scanning the light beam 112 along a two-dimensional scan path 302, e.g. to scan the light beam 112 across a plurality of probing positions 116 arranged in a two-dimensional array as illustrated in Fig. 3. The scan path 302 may for example comprise a plurality of parallel segments, e.g., connecting the probing positions 116 along a respective row of the two-dimensional array, as well as a plurality of interconnecting segments between adjacent parallel segments (i.e., have a zigzag or saw tooth shape as shown in Fig. 3). In some examples, the probing position 116 may be arranged in an irregular (e.g., random) array and may for example be positions within the sensing area or layer 108 at which the solid-state spin systems exhibit the best sensing properties (e.g., the longest spin-lattice and/or spin-spin relaxation times).

The probing positions 116 within the array may be spatially separated from each other by a spacing that is larger than a diameter of the illumination spot 114 (i.e., a diameter of the light beam 112 at the sensing layer 108) such that the illumination spot 114 only illuminates (at most) a single probing position 116 at a time as illustrated in Fig. 3. The spacing between the probing positions 116 may for example be between 2 and 20 times, in some examples between 3 and 10 times the diameter of the illumination spot 114. In other examples, the probing positions 116 may be closer together than the diameter of the illumination spot 114 and may in particular be arranged continuously along the scan path 302 (e.g., with an infinitesimally small spacing between adjacent probing positions 116).

The device 300 further comprises a microwave applicator 304 for applying microwave electromagnetic fields to the solid-state spin systems in the sensing layer 108. The microwave applicator 304 may for example be embodied as a microwave antenna (for emitting microwave radiation) and/or a microwave resonator (e.g., for resonant enhancement of the microwave electromagnetic fields). In the example of Fig. 3, the microwave 304 is embodied as a microwave stripline as the simplest form of a microwave antenna. A resonance frequency of the microwave antenna/resonator 304 may be adapted to an energy spectrum of the solid-state spin systems, e.g., resonant with or slightly detuned from a transition between states, in particular spin states, of the solid-state spin systems. The microwave applicator 304 may be configured to be coupled to a microwave generator or source generating a microwave signal, for example via a suitable connector, e.g. as described below for the device 400 of Fig. 4.

Fig. 4 depicts yet another example of a device 400 for probing optically addressable solid-state spin systems in side view (not to scale). The device 400 is similar to the devices 100, 300 of Figs. 1 and 3, respectively, with corresponding elements being denoted by the same reference signs. In particular, the device 400 also comprises a substrate 104 comprising a plurality of solid-state spin systems arranged in a sensing area 108 as well as an illumination system 110 with an optical deflector 120 for directing a light beam 112 onto a movable illumination spot in the sensing area 108. In contrast to the example of Fig. 1, the solid-state spin systems in Fig. 4 are not confined to a surface layer below a sampling surface but are arranged in the bulk of the substrate 104, e.g., distributed throughout the entire substrate 104. In this example, the solid-state spin systems themselves may be the "samples" to be probed. Additionally or alternatively, a surface of the substrate 104 such as its upper surface (i.e., the surface facing away from the imaging system 410) may be used as a sampling surface for arranging samples thereon as described above, wherein the sensing area 108 may then, e.g., be embodied as a sensing layer below this sampling surface as also described above.

The device 400 further comprises a magnet for applying a bias magnetic field to the solid-state spin systems in the sensing area 108. In the example of Fig. 4, the magnet is formed by a pair of coils 402A, 402B that are arranged adjacent to the substrate 104 and configured to be connected to a current source (not shown) for applying the bias magnetic field. In some examples, the device 400 may also comprise the current source. The device 400 may for example be configured to apply a bias magnetic field with a variable field strength, which may, e.g., be adjusted within the range of 0 mT to 1 T, in one example within the range of 0 T and 5 T. The bias magnetic field may for example be used to define a quantization axis for the solid-state spin systems and/or adjust an energy splitting between states, in particular spin states, of the solid-state spin systems. In a preferred embodiment, the magnet is configured (e.g., constructed and/or mounted in a way) to allow for an alignment of the magnetic field direction with a desired quantization axis of the solid-state spin systems, e.g., a crystal axis of the host crystal/ substrate.

The device 400 also comprises a light source 404 (e.g., as part of the illumination system 110), for example a laser, for generating the light beam 112. The illumination system 110 may comprise one or more lenses 406, for example for collimating the light beam 112 as generated by the light source 404 and/or for focusing the light beam 112 onto or in the vicinity of the optical deflector 120 and/or the sensing layer 108. The illumination system 110 may also comprise one or more mirrors 408, for example to couple the (incoming) light beam 112 into the optical deflector 120 and/or for moving the illumination spot across the sensing layer 108.

The device 400 further comprises an imaging system 410 that is configured to collect light emitted by the solid-state spin systems in the sensing layer 108 and image the emitted light onto a photodetector 412 of the device 400. The photodetector 412 may in particular be a point-like photodetector (i.e., a spatially non-resolving photodetector) such as an avalanche photodiode. The imaging system 410 may be configured to image the entire sensing area 108 onto the (e.g., point-like) photodetector 412, i.e., such that light emitted from solid-state spin systems throughout the sensing area 108 (e.g., irrespective of where the illumination spot is located) may be detected by the photodetector 412. For this, the imaging system 410 may for example comprise an objective, in particular a high-NA objective.

In some embodiments, the light beam 112, in particular the deflected light beam, may share a common optical path with the emitted light 118 imaged onto the photodetector 412 by the imaging system 410 (with the latter propagating in the opposite direction). For example, the light beam 112 may be coupled into an optical path of the imaging system 410, e.g., using a dichroic mirror (which may for example reflect the light beam 112 while transmitting the emitted light 118 or vice-versa, thereby allowing to combine and/or separate the light beam 112 and the emitted light 118). In one example, the light beam 112 is coupled into the optical path of the imaging system 410 so as to pass through the objective of the imaging system 410. This may for example allow for focusing the light beam 112 onto a small illumination spot.

In some examples, the imaging system 410 and/or the photodetector 412 may be configured so as to allow for both spatially resolved and spatially non-resolved imaging. The photodetector 412 may for example be a spatially resolving photodetector such as a CMOS chip or camera and the imaging system may be configured to image a plurality of probing positions and/or sensing regions onto a same pixel (which constitutes a spatially non-resolving photodetector) of the spatially resolving photodetector (e.g., the CMOS chip or camera). Intensities of the light detected by a given pixel at different points in time may then be associated with a respective probing position or sensing region based on a scan order of the light beam across the plurality of probing positions or sensing regions. By such "time multiplexing", the resolution of the spatially resolving photodetector may effectively be enhanced. The device 400 also comprises a microwave generator 414 that is configured to generate a microwave signal, in particular one or more microwave pulses and/or a microwave pulse sequence, to be coupled into the microwave applicator 304 for applying microwave electromagnetic fields to the solid-state spin systems in the sensing area 108.

The device 400 further comprises a controller 416 that is configured to control some or all of the other components of the device 400, in particular some or all of the light source 404, the illumination system 112 (e.g., the optical deflector 120), the imaging system 410, the photodetector 412 and the microwave generator 414. The controller 416 may be embodied in hardware, software or a combination thereof. The controller 416 may for example comprise a processor such as one or more of a central processing unit (CPU), a graphics processing unit (GPU), an application-specific integrated circuit (ASIC) and/or a field-programmable gate array (FPGA). The controller 416 may further comprise a memory, e.g., a non-volatile memory and/or a volatile memory, storing instructions for execution by the processor to provide the functionality described herein. In some examples, the controller 416 may be embodied as a microcontroller. The controller 416 may be provided as a single unit or may be distributed throughout the device 400, e.g., integrated into other components of the device 400. The controller 416 may in particular be configured to execute some or all steps of a method for probing optically addressable solid-state spin systems according to any one of the embodiments disclosed herein, for example some or all steps of method 200 and/or method 500.

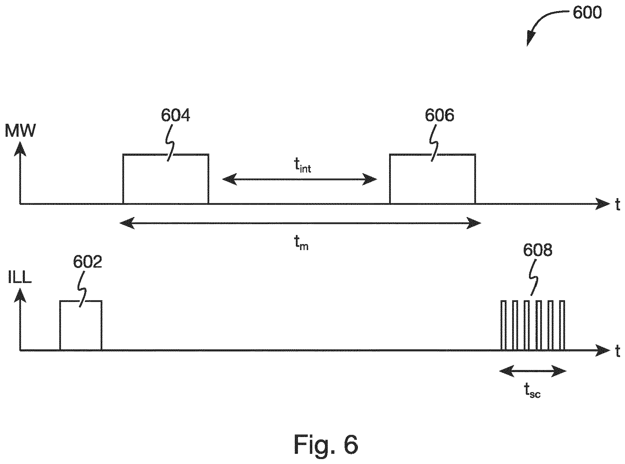

Fig. 5 shows a flow diagram of a method 500 for probing optically addressable solid-state spin systems at a plurality of probing positions in accordance with another example. Fig. 6 depicts an exemplary sequence of microwave and illumination pulses for the method 500. The method 500 may for example be executed using a device for probing optically addressable solid-state spin systems according to any one of the embodiments disclosed herein such as the device 400 of Fig. 4, which is used as a non-limiting example for illustrative purposes in the following. The method 500 is similar to the method 200 of Fig. 2 and may in particular also be used for probing one or more samples 102 using the optically addressable solid-state spin systems as probes, e.g., by arranging the samples 102 on the sampling surface 106 above the sensing area/layer 108 adjacent to one or more sample probing positions 116A as described above.

The method 500 may comprise, in step 502, initializing the solid-state spin systems in an initial state, e.g., in a particular electronic and/or spin state (for example the electronic and/or spin ground state). This may for example comprise illuminating solid-state spin systems in the sensing area/layer 108 by one or more (optical) illumination pulses 602 to optically excite the solid-state spin systems, e.g., for optical polarization or optical pumping. The solid-state spin systems may for example be illuminated using the light source 404 and/or the illumination system 110. The solid-state spin systems in the sensing area/layer 108 may be illuminated uniformly throughout the entire sensing area/layer 108 or selectively at the probing positions 116 and/or the sensing regions 115. The solid-state spin systems in the sensing area/layer 108 may be illuminated simultaneously or sequentially, for example by sequentially scanning the light beam 112 across the plurality of probing positions as in or similar to step 506 and/or method 200.

The method 500 may further comprise, in step 504, performing a measurement sequence for probing the samples 102 using the solid-state spin systems in the sensing area/layer 108. The solid-state spin systems may for example be used as quantum sensors for sensing magnetic and/or electric fields, e.g., for performing NMR and/or ESR spectroscopy, but additionally or alternatively also for sensing other physical observables such as for example temperature. The measurement sequence in step 504 may serve to encode information pertaining to the samples 102 and/or the quantity to be sensed in a state of the solid-state spin systems. Preferably, the measurement sequence - in contrast to the sequential readout in step 506 - is performed simultaneously at all probing positions 116 (e.g., simultaneously throughout the entire sensing area/layer 108).

The measurement sequence may comprise allowing the solid-state spin systems at the sample probing positions 116B to interact with the respective sample 102 for an interaction period tᵢₙₜ in step 504B. During the interaction period tᵢₙₜ, the state of the solid-state spin systems may evolve freely (e.g., without applying any microwave pulses and/or optical illumination thereto) under the influence of the respective sample 102 (i.e., the interaction period tᵢₙₜ may constitute an example of a free evolution period or duration as described above). The interaction period tᵢₙₜ may be chosen appropriately depending on the type of probing or measurement to be performed. The interaction period tᵢₙₜ may be variable and may for example be varied (e.g., increased or decreased incrementally) between different repetitions or iterations of method 500 (as indicated by the dashed arrow in Fig. 5).

The measurement sequence may further comprise manipulating a spin state of the solid-state spin systems at the probing positions 116 by applying microwave electromagnetic fields using the microwave applicator 304 and/or the microwave generator 414. This may for example comprise applying a first sequence of one or more microwave pulses 604 in step 504A prior to the interaction period tᵢₙₜ in step 504B and/or applying a second sequence of one or more microwave pulses 606 in step 504C after the interaction period tᵢₙₜ in step 504B. The microwave pulse sequences 604, 606 are not particularly limited and each may for example comprise one or more π/2 pulses and/or one or more π pulses. The microwave pulse sequences 604, 606 may in particular be pulse sequences as commonly used for NMR and/or ESR spectroscopy, for example a dynamic decoupling sequence such as an XY8-N sequence, e.g., as described in D. B. Bucher et al., Nat. Protoc. 14, 2707-2747 (2019*).* The method 500 may further comprise applying a bias magnetic field, for example using the coils 402A, 402B, during some or all steps thereof, in particular during some or all of the measurement sequence in step 504. In some examples, step 504 may comprises repeatedly executing some or all of steps 504A, 504B and 504C, e.g., using different interaction periods tᵢₙₜ.

In step 506, a rapid sequential readout of the state of the solid-state spin systems at the plurality of probing positions 116 is performed by optical means. This readout comprises sequentially scanning the light beam 112 across the plurality of probing positions 116 and, at each probing position 116, illuminating solid-state spin systems at the respective probing position 116 with the light beam 112 (resulting in illumination pulse sequence 608 in Fig. 6) by repeated execution of steps 506A and 506B as described above for method 200. The readout is performed within a scanning duration t_{sc}, which is shorter than three times the spin-lattice relaxation time (t_{sc} < 3 * T1) and/or shorter than three times the spin-spin relaxation time (t_{sc} < 3 * T2) of the solid-state spin systems in the sensing layer 108. Preferably, the scanning duration t_{sc} is shorter than, in some examples substantially shorter than (e.g., shorter than 50%, preferably shorter than 20% of) one or both of the spin-lattice relaxation time and the spin-spin relaxation time of the solid-state spin systems in the sensing layer 108. This may reduce the loss of information pertaining to the spin state of the solid-state spin systems following the measurement sequence in step 504. Preferably, the scanning duration t_{sc} is also shorter, in some examples substantially shorter than a total duration tₘ of the measurement sequence in step 504 (referred to as the measurement duration herein), for example the time between the beginning of the first sequence of microwave pulses 604 and the end of the second sequence of microwave pulses 606 as illustrated in Fig. 6.

The readout may further comprise detecting light emitted by the solid-state spin systems at each of the probing positions 116 upon illumination with the light beam 112 using the photodetector 412 in step 506B. Preferably, the photodetector 412 is a point-like photodetector such as an avalanche photodiode, which may offer improved sensitivity over spatially resolving photodetectors such as CMOS chips or cameras. As the probing positions 116 are illuminated sequentially following a known scan path 302, spatial information pertaining to the origin of the detected light may be obtained based on the point in time at which the light is detected. The intensities of the light detected by photodetector 412 at different points in time may thus be associated with a respective one of the probing positions based on a scan order (e.g., the scan path 302) of the light beam 112 across the probing positions 116, namely with the probing position that the light beam 112 has been moved to in step 506A (current probing position) prior to the illumination and detection in step 506B. Thereby, a map (e.g., a one-dimensional or two-dimensional map) of the detected light along the scan path 302 may be reconstructed, thus allowing for spatially resolved probing even with a point-like photodetector 412, which in itself is not capable of distinguishing between the light originating from different probing positions (but may offer improved sensitivity as compared to spatially resolving sensors).

In some examples, the photodetector 412 may be a spatially resolving photodetector comprising a plurality of point-like photodetectors (pixels). Light emitted by the solid-state spin systems at a plurality of probing positions 116 upon illumination with the light beam 112 may be detected using a same one of the plurality of point-like photodetectors/pixels. Spatially resolved information pertaining to said plurality of probing positions 116 imaged onto the same pixel may be reconstructed by "time-multiplexing" similar to the single point-like photodetector, thereby effectively enhancing the resolution of the spatially resolving photodetector.

In addition to the steps described above, the method 500 may comprise further steps in some examples. The method 500 may for example comprise performing differential measurements on the sample probing positions 116A using the reference probing positions 116B, which are not adjacent to any sample 102, as a reference. Additionally or alternatively, the method 500 may also comprise repeatedly executing steps 502 to 506 (as illustrated by the dashed arrow in Fig. 5), for example on the same probing positions 116 (e.g., to improve a signal-to-noise ratio and/or a measurement uncertainty and/or using different interaction periods) and/or on different probing positions 116 (e.g., to probe additional samples 102 and/or different portions of the same samples 102). Simultaneously performing the measurement sequence in step 504 on a plurality of probing positions in combination with the fast sequential redout in step 506 may drastically reduce the time required for executing measurements (e.g., as compared to performing sequential measurements on each of the probing positions individually) and may thus allow for rapidly repeating steps 502 to 506 many times on a large number of probing positions in parallel, which may yield substantially improvements in sensitivity and signal-to-noise ratio.

The embodiments of the present invention disclosed herein only constitute specific examples for illustration purposes. The present invention can be implemented in various ways and with many modifications without altering the underlying basic properties. Therefore, the present invention is only defined by the claims as stated below.

### LIST OF REFERENCE SIGNS

100 - device for probing optically addressable solid-state spin systems
102 - sample
104 - substrate
106 - sampling surface
108 - sensing area/layer
110 - illumination system
112 - light beam
112A - incoming light beam
112B - deflected light beam
114 - illumination spot
115 - sensing region
116 probing position
116A sample probing positions
116B - reference probing position
118 - emitted light/luminescence
120, 120A, 120B - optical deflector/acousto-optic modulator and/or deflector
200 - method for probing optically addressable solid-state spin systems
202 - step of moving light beam to next probing position
204 - step of illuminating solid-state spin systems at current probing position
300 - device for probing optically addressable solid-state spin systems
302 - scan path
304 - microwave applicator
400 - device for probing optically addressable solid-state spin systems
402A, 402B - magnet/coil
404 - light source
406 - lens
408 - mirror
410 - imaging system
412 - photodetector
414 - microwave and/or radio-frequency generator
416 - controller
500 - method for probing optically addressable solid-state spin systems
502 - step of initializing solid-state spin systems
504 - step of performing measurement sequence
504A - step of performing first microwave manipulation
504B - step of allowing the solid-state spin systems to evolve freely/interact with the samples 102
504C - step of performing second microwave manipulation
506 - step of performing sequential optical readout of solid-state spin systems
506A - step of moving light beam to next probing position
506B - step of illuminating spin systems at current probing position
600 - microwave and illumination pulse sequences
602 - illumination pulse(s) for initialization
604 - first microwave pulse sequence
606 - second microwave pulse sequence
608 - readout illumination pulses
d - lateral extent of sensing area/layer 108
ω, ωₓ, ω_{y} - frequency of control signal for optical deflector 120, 120A, 120B t_{sc} - scan duration
tₘ - measurement duration
tᵢₙₜ - interaction period

## Claims

1. A method (200, 500) for probing optically addressable solid-state spin systems at a plurality of probing positions (116), the method (200, 500) comprising:
sequentially scanning a focused light beam (112) across said plurality of probing positions (116) and, at each probing position (116), illuminating solid-state spin systems at the respective probing position (116) with said focused light beam (112),
wherein a scanning duration (t_{sc}) within which said focused light beam (112) is scanned across said plurality of probing positions (116) is shorter than three times a spin-lattice relaxation time of said solid-state spin systems and/or shorter than three times a spin-spin relaxation time of said solid-state spin systems.

2. The method (200, 500) of claim 1, wherein said solid-state spin systems are or comprise diamond color centers, in particular nitrogen-vacancy centers in diamond; spin defects in a van-der-Waals material; and/or spin defects in a semiconductor material, in particular spin defects in silicon carbide.

3. The method (200, 500) of claim 1 or 2, wherein said scanning duration (t_{sc}) is shorter than said spin-lattice relaxation time, preferably shorter than 50% of said spin-lattice relaxation time, most preferably shorter than 20% of said spin-lattice relaxation time, and/or wherein said scanning duration (t_{sc}) is shorter than said spin-spin relaxation time, preferably shorter than 50% of said spin-spin relaxation time, most preferably shorter than 20% of said spin-spin relaxation time.

4. The method (200, 500) of any one of the preceding claims, wherein said focused light beam (112) is scanned across said plurality of probing positions (116) by deflecting the focused light beam (112) along one or two directions by one or more acousto-optic modulators and/or deflectors (120) and/or one or more electro-optic modulators and/or deflectors.

5. The method (200, 500) of any one of the preceding claims, wherein:
said probing positions (116) are spatially separated from each other and a spacing between adjacent probing positions is larger than a diameter of said focused light beam (112), preferably larger than two times the diameter of said focused light beam (112), in particular wherein said probing positions (116) are arranged in a one-dimensional or two-dimensional array; and/or
a spacing between adjacent probing positions is smaller than a diameter of said focused light beam (112), preferably smaller than 50% of the diameter of said focused light beam (112).

6. The method (200, 500) of any one of the preceding claims, further comprising manipulating a spin state of solid-state spin systems at two or more, preferably at all of said probing positions (116) simultaneously using microwave and/or radio-frequency electromagnetic fields.

7. The method (200, 500) of any one of the preceding claims, further comprising:
initializing solid-state spin systems at said plurality of probing positions (116) in an initial state; and
subsequently performing a measurement sequence on said solid-state spin systems at said plurality of probing positions (116) prior to sequentially scanning said focused light beam (112) across said plurality of probing positions, said measurement sequence comprising one or both of a free evolution of the spin state of said solid-state spin systems and manipulating the spin state of said solid-state spin systems using microwave and/or radio-frequency electromagnetic fields,
wherein said scanning duration (t_{sc}) is shorter than a measurement duration (tₘ) of said measurement sequence, preferably shorter than a free evolution period (tᵢₙₜ) of said free evolution of the spin state of said solid-state spin systems.

8. The method (200, 500) of any one of the preceding claims, further comprising, for some or all probing positions (116), detecting light emitted by the solid-state spin systems at the respective probing position (116) upon illumination with said focused light beam (112) using a photodetector (412), in particular a same point-like photodetector (412), wherein the method (200, 500) preferably further comprises associating intensities of the light detected by said point-like photodetector (412) at different points in time with a respective one of said plurality of probing positions (116) based on a scan order of said focused light beam (112) across the plurality of probing positions (116).

9. The method (200, 500) of any one of the preceding claims, wherein said plurality of probing positions (116) comprises one or more sample probing positions (116A) that are adjacent to a sample (102) to be probed using said solid-state spin systems and one or more reference probing positions (116B) that are not adjacent to any sample (102) to be probed using said solid-state spin systems.

10. A device (100, 300, 400) for probing optically addressable solid-state spin systems, the device (100, 300, 400) comprising:
a substrate (104) comprising a plurality of optically addressable solid-state spin systems arranged in a sensing area (108) within said substrate (104); and
an illumination system (110) configured to direct a light beam (112) onto an illumination spot (114) in said sensing area (108) for optically exciting solid-state spin systems within said illumination spot (114),
wherein said illumination system (110):
comprises an optical deflector (120) configured to deflect said light beam (112) for laterally moving said illumination spot (114) across said sensing area (108); and
is configured to move said illumination spot (114) across a lateral extent (d) of said sensing area (108) within three times a spin-lattice relaxation time of said solid-state spin systems and/or within three times a spin-spin relaxation time of said solid-state spin systems.

11. The device (100, 300, 400) of claim 10, wherein said solid-state spin systems are or comprise diamond color centers, in particular nitrogen-vacancy centers in diamond; spin defects in a van-der-Waals material; and/or spin defects in a semiconductor material, in particular spin defects in silicon carbide.

12. The device (100, 300, 400) of claim 10 or 11, wherein:
said illumination system (110) is configured to move said illumination spot (114) across the lateral extent (d) of said sensing area (108) within said spin-lattice relaxation time, preferably within less than 10% of said spin-lattice relaxation time, most preferably within less than 5% of said spin-lattice relaxation time, and/or within said spin-spin relaxation time, preferably within less than 10% of said spin-spin relaxation time, most preferably within less than 5% of said spin-spin relaxation time; and/or
said optical deflector (120) is or comprises one or more acousto-optic modulators and/or deflectors (120) configured to deflect said light beam (112) along one or two directions and/or one or more electro-optic modulators and/or deflectors configured to deflect said light beam (112) along one or two directions.

13. The device (100, 300, 400) of any one of claims 10 to 12, wherein said substrate (104) comprises a sampling surface (106) for arranging one or more samples (102) thereon and said sensing area (108) is a sensing layer below said sampling surface (106), in particular wherein said illumination system (110) is configured to direct said light beam (112) onto the illumination spot (114) in said sensing layer (108) such that said light beam (112) is reflected at said sampling surface (106) and/or at a surface of the sensing layer (108), in particular by total internal reflection.

14. The device (100, 300, 400) of any one of claims 10 to 13, further comprising:
a microwave and/or radio-frequency applicator (304), in particular a microwave and/or radio-frequency antenna and/or a microwave and/or radio-frequency resonator, for applying microwave and/or radio-frequency electromagnetic fields to the solid-state spin systems in said sensing area (108); and/or
a photodetector (412), in particular a point-like photodetector and/or a spatially resolving photodetector, and an imaging system (410) for imaging light emitted by the solid-state spin systems in said sensing area (108) onto said photodetector (412); and/or
one or both of a light source (404) configured to generate said light beam (112) and a microwave and/or radio-frequency generator (414) configured to generate a microwave signal and/or a radio-frequency signal.

15. The device (100, 300, 400) of any one of claims 10 to 14, further comprising a controller (416) configured to execute a method (200, 500) according to any one of claims 1 to 9 by controlling one or more of said illumination system (110), said photodetector (412), said imaging system (410), said light source (404) and said microwave and/or radio-frequency generator (414).
